# EUROPEAN PATENT APPLICATION

(11) **EP 2 597 736 A1**
(43) Date of publication of application: **29.05.2013**
(21) Application number: 11306532.0
(22) Date of filing: 22.11.2011
(51) Int. Cl.: H01S 5/14, H01S 5/10, G02B 6/293

(54) **Hybrid Laser**

(71) Applicant: Alcatel Lucent, 75007 Paris (FR)
(72) Inventor: Rasras, Mahmoud, MURRAY HILL, NJ New Jersey 07974-0636 (US); Earnshaw, Mark Peter, MURRAY HILL, NJ New Jersey 07974-0636 (US)
(74) Representative: Shamsaei Far, Hassan

(57) **Abstract**

A laser (1) comprising a semiconductor optical amplifier (11) constructed in an InP material and a planar lightwave circuit filter (12) constructed in silica. The semiconductor optical amplifier (11) and the planar lightwave circuit filter (12) are integrated in a hybrid structure on a single substrate. The planar lightwave filter comprises a first wavelength filter (121), a second wavelength filter (122) which in combination produces a plurality of wavelengths. The laser (1) further comprises a third wavelength filter (127) coupled to the first wavelength filter and the second wavelength filter and configured to allow a selected number of wavelengths from said plurality of wavelengths to pass through said third wavelength filter.

## Description

The present invention relates to optical components.

### BACKGROUND ART

Coherent polarization-multiplex quadrature phase shift keying (PM-QPSK) advance transmission format is expected to be used in future optical networks, typically, with a view of providing efficient use of spectral bandwidth. Such format may typically be used in long-haul and ultra-long-haul (LH/ULH) DWDM systems. However, the increased spectral efficiency may typically require more complex receiver frontends. For example, the optical frontend of a single channel PM-QPSK receiver may typically require mixing the incoming signal with a local oscillator (LO). 90°-hybrids are typically used for combining the incoming signal with the local oscillator signal.

### SUMMARY

Currently there is an increasing trend toward providing optical components in integrated form. Integration of various elements of a device onto a single chip has several advantages such as reduced cost, power consumption and footprint of the overall component. In this regard, integration of the LO with 90°-hybrids as mentioned above and the ability to fine tune the output frequency of the LO will likely play a critical role in reducing the cost and size of the overall end product. However lasers intended for use as local oscillators would also be expected to exhibit a wide tuning range, for example of more than about 40 nm, and be capable of providing a relatively high output power (of about or above 18 dBm). Another desired property of such devices is that the wavelength of the laser should preferably have high wavelength stability and ultra-narrow linewidth (about 100 kHz).

One known solution for providing tunable lasers uses resonance-coupled lasers which are monolithically integrated components in an InP Platform. A laser made according to this solution typically has a gain region, a phase control region, and two microring resonators with different free spectral ranges (FSRs) to achieve a wide tuning range. Vernier effect may be used to provide precision in tuning so as to obtain a wide tuning range, where the two filters (.i.e. the two ring resonators) with different FSRs have a comb-like filter response. Typically, the total tuning range of the laser, when using the vernier effect, strongly depends on the difference between the FSRs of the two filters.

Whilst lasers made according to the above known solution may achieve high performance, they typically suffer from drawbacks with respect to co-packaging them with a coherent mixer. Some of such drawbacks are related to parasitic reflections in monolithically integrated InP chips which are typically significantly worse than in hybrid-integrated chips which in turn may typically adversely affect laser performance. Furthermore the co-packaging may typically significantly increase cost, the physical size of the module and the number of packages related to the individual lasers and filters.

Furthermore, temperature control may also become problematic in the InP chip which is typically very temperature sensitive. Typically a tight temperature control is needed for suppressing frequency drifts caused by thermal transients (usually occurring over a long time constant) between the ring resonators. In addition, some cross-talk may exist between neighboring channels and in order to reduce such cross-talk, it may be desirable to reduce the frequency drift of the laser, thereby requiring additional control measures.

Embodiments of the disclosure feature a hybrid laser for use as a local oscillator and capable of being in turn integrated in a hybrid manner with a mixer, for example a 90°-hybrid. Such solution would significantly contribute in reducing the physical size of the device (and thereby the size of the overall system incorporating such laser) because a number of packages related to the individual lasers and filters may be eliminated.

Some embodiments of the disclosure feature a tunable laser comprising a semiconductor optical amplifier constructed in an InP material and at least one planar lightwave circuit filter constructed in silicon-based material, the semiconductor optical amplifier and the planar lightwave circuit filter being integrated in a hybrid structure on a common substrate, wherein the at least one planar lightwave filter comprises a hybrid structure including a first wavelength filter having a first free spectral range and a second wavelength filter having a second free spectral range, the first free spectral range being different from the second free spectral range such that in use, a combined effect of the first wavelength filter and the second wavelength filter produces a plurality of wavelengths; the laser further comprises a third wavelength filter coupled to the first wavelength filter and the second wavelength filter and configured to allow a selected number of wavelengths from said plurality of wavelengths to pass through said third wavelength filter.

Preferably the laser is adapted to operate in the C-band or in the L-band. According to some specific embodiments, the semiconductor optical amplifier structure in the InP material and the planar waveguide circuit filter in the silicon-based material are distinct dies mounted on a common substrate.

According to some specific embodiments, the semiconductor optical amplifier structure in the InP material and the planar waveguide circuit filter in the silicon-based material are wafer-bonded structures on a common substrate.

According to some specific embodiments, the silicon-based material is silica, or silicon or silicon nitride or polymer-on-silicon.

According to some specific embodiments, the third wavelength filter is a Mach-Zehnder interferometer.

According to some specific embodiments, the first wavelength filter is a ring resonator.

According to some specific embodiments, the second wavelength filter is a ring resonator.

According to some specific embodiments, the Mach-Zehnder interferometer is tunable to a maximum transmittance of the planar lightwave circuit filter.

Some embodiments relate to a receiver comprising the laser as featured herein. Some embodiments relate to a transmitter comprising the laser as featured herein.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary schematic representation of a laser device according to some embodiments.
Figure 2 is a graphical representation by simulation of a transmittance response of a laser device for varying wavelengths.
Figures 3 is a graphical representation by simulation of a transmittance response for varying wavelengths of the laser device of figure 1 according to some embodiments.
Figure 4 is a graphical representation by simulation of a transmittance response for varying wavelengths of the laser device of figure 1 according to some embodiments.
Figure 5 is an exemplary schematic representation of a laser device according to some embodiments.

### DETAILED DESCRIPTION

For the sake of clarity of the present disclosure, it is to be noted that by the terms, hybrid-integrated, it is meant to refer to a device comprising individual components which are grouped on a single, or common, substrate. A common substrate may comprise more than one wafer bonded together. A hybrid-integrated device may in turn be integrated with other components to form another hybrid-integrated device.

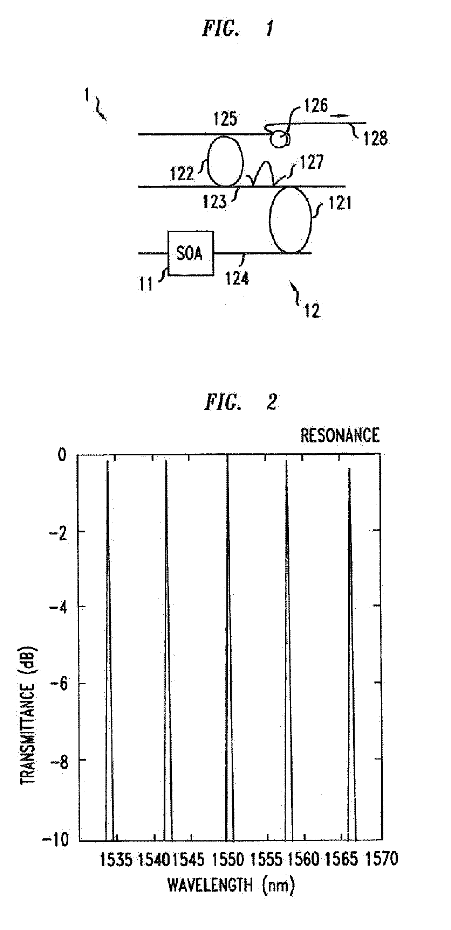

Figure 1 schematically exemplifies a hybrid-integrated tunable laser device 1 according to some embodiments. The device 1 comprises an active semiconductor optical amplifier (SOA) 11 coupled in a hybrid manner to a planar lightwave circuit (PLC) which in the figure is shown by the general reference numeral 12. The PLC is adapted to provide filter functionality as will be described below. The structure of the SOA may be made using InP material and that of the PLC filter may be made using silicon, silicon nitride, polymer-on-silicon or silica (herein generally referred to as silicon-based material). As the laser is hybrid-integrated the construction of such laser using such different materials is easily achievable. The coupling of the SOA 11 with the PLC 12 may be made by known means using for example a butt-coupled or a flip-chipped approach.

The SOA 11 may be made separately from the PLC 12 on a die of an InP material and then mounted on a common substrate with the PLC 12 in hybrid manner. Alternatively the SOA 11 may be made by epitaxial growth on the InP material that is wafer bonded in a hybrid manner to the PLC 12 wafer and then processed along with the PLC wafer on a common substrate.

The PLC 12 may comprise two or more ring resonators 121 and 122. The ring resonators have wavelength filtering as well as phase shifting capabilities and may have different free spectral ranges in order to provide the possibility of broadening the tuning range of the filter. In the non-limiting example of figure 1, two ring resonators are used for a laser resonance capacity in the C-band (typically 1530-1565 nm).

The ring resonators 121 and 122 are coupled to each other through a first waveguide 123. The ring resonator 121 is also coupled, at a different port, to the SOA 11 by means of a second waveguide 124 while the ring resonator 122 is coupled to a reflective element 126 by means of a third waveguide 125. The reflective element 126 may be for example a 3dB splitter/combiner. The reflective element 126 is configured to reflect an optical signal generated by the SOA 11 which has propagated through the two ring resonators 121 and 122.

The PLC further comprises a Mach-Zehnder interferometer (MZI) 127, the functionality of which will be described further below.

The combined structure of the SOA 11, the waveguides 123, 124, 125, the MZI 127 and the reflective element 126 may therefore provide the effect of a laser cavity for the laser. The reflective element 126 is further coupled to the output of the laser by means of output waveguide 128.

With this arrangement, the combined effect of the two ring resonators, as optical signal propagates back and forth through them, provides interference between the respective transfer functions of the resonators, based on the so-called vernier effect, in order to eliminate unwanted frequencies of the optical signal. According to the vernier effect, each ring resonator may operate as a wavelength filter and may have an FSR which is different from the (or at least one) other ring resonator through which the optical signal propagates. The difference in the FSRs of the ring resonators produces a combined effect on the resulting waveform, as some of the (unwanted) frequencies may cancel each other while a particular (wanted) frequency from each waveform may add up to produce the optical signal to be output from the laser.

Therefore, the shape of the combined waveform depends on such difference in the respective FSRs of the ring resonators. Consequently, by appropriately determining the difference in the FSR of the ring resonators, one may be able to determine the wavelength at which a maximum (or at least an optimum) transmittance of the laser may be obtained and thereby tune the response of the laser to that particular wavelength.

In figure 2 a transmittance response is shown for comparison purposes. Such a response would be provided if, instead of the two ring resonators and the MZI of figure 1, only two ring resonators were used (i.e. the MZI not being used). As may be appreciated in this figure, the resulting wave-shape is in the form of a comb, as is known in the related art.

Also for the sake of comparison, if only one ring resonator was used in the device of figure 1, the response would also be in the form of a comb. However, the FSR of the generated wave-shape would typically be comparatively smaller than that generated with two ring resonators. For example, in case silica waveguide is used, as the bend radius of such waveguide relatively small ~1mm, one ring resonator would generate a comb like response with FSR of ~25GHz; whereas the use of two ring resonators (and the presence of the vernier effect) allows for generating a comb-like response with relatively larger FSR as shown in the example of figure 2.

In some embodiments of the structure of figure 1 using two silica-based ring resonators, the free spectral ranges of the ring resonators may be 25 and 24.4GHz respectively for a bending radius of about 1 mm, which is considered to be relatively large. However, according to embodiments of the present disclosure, such ring resonators may be integrated with an imbalanced Mach-Zehnder (MZI) to achieve tunability across the entire band as will be described in further detail below.

Preferably, the FSRs of the ring resonators are chosen such that the difference between the FSRs of at least two ring resonators is smaller than about 1 GHz in order to provide responses that may cover broader bandwidths.

Those skilled in the related art would realize that the filtering arrangement PCL 12 may comprise more that two ring resonators wherein at least two of the ring resonators have different FSRs.

Although the use the combined effect of two or more wavelength filters (in this example, ring resonators) is capable of producing responses with maximum (or optimum) transmittance of the laser at desired wavelengths, such responses may in practice not be ideal. Indeed, in addition to the maximum (or optimum) transmittance, there typically still remain lateral frequencies of the resulting response (in the form of a comb) with certain transmittance values which may still be undesired and needed to be further filtered out. Referring back to figure 2 an example of such a comb-shape response may be observed with a number of wavelengths, wherein some of the responses may be undesired for a specific use. Furthermore such undesired frequencies may cause mode-hopping in the laser (sudden jumps in the operating mode of the laser between various transmittance values).

In order to remove such undesired frequencies, the ring resonators may be integrated, in a hybrid manner, together with an imbalanced Mach-Zehnder interferometer (MZI) 127 (figure 1). Such MZI may preferably have an FSR chosen such that by way of an additional filtering effect caused by the MZI, the above-mentioned undesired frequencies (i.e. frequencies that are not aligned to the maximum transmittance of the laser) may be suppressed. Therefore, by aligning the passband of the MZI with the combined passband of the ring resonators at any given frequency, only the desired wavelength (or wavelengths) may be allowed to pass. This enables a more precise tunability of the laser across the entire band as required.

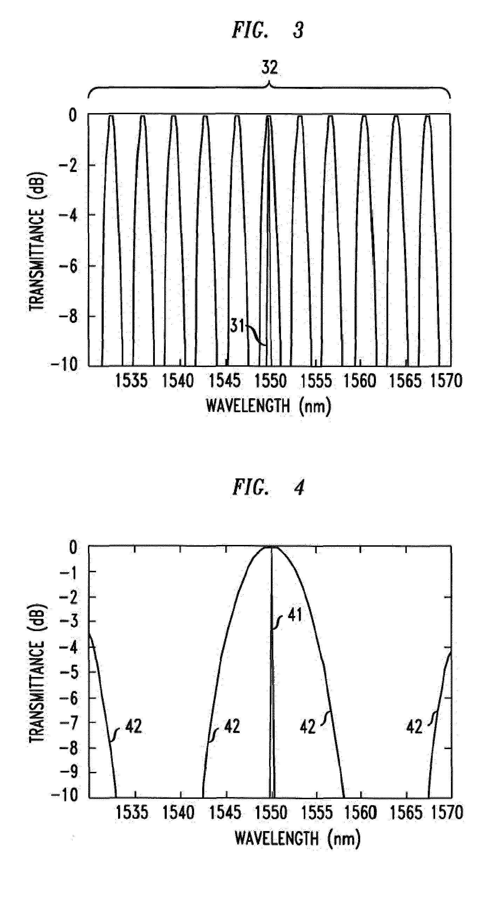

Figures 3 and 4 show respective graphical representations of responses of a laser when two exemplary FSR values are used for the MZI 127 of figure 1.

The graphic of figure 3 relates to exemplary transmittance transfer functions of two ring resonators represented by reference numeral 31 and an MZI filter transmittance transfer function generally represented by reference numeral 32. In this case, the MZI has an FSR of about 875 GHz which is a relatively narrow value.

Similarly, the graphic of figure 4 corresponds to exemplary transmittance transfer functions of two ring resonators represented by reference numeral 41 and an MZI filter transmittance transfer function generally represented by reference numeral 42. However, in this case, the MZI has an FSR of about 6250 GHz which is a larger value as compared to the FSR for the MZI of figure 3.

As it is comparatively appreciated from these figures, different FSR values produce different transmittance waveforms for the same MZI.

Each FSR in figures 3 and 4 is shown in combinations with a particular laser wavelength (in this case 1550 nm). The choices between the two MZI FSR configurations may be made, for example, based on thermal tuning budget. For example, to tune the laser frequency across the full C-band, the MZI FSR of figure 3 is more desirable because smaller but more numerous transmittance wavelengths of the MZI allow for a wider band through which the laser response may be tuned.

On the other hand, for a limited tunability of the laser output (i.e. a narrower output frequency range), for example where it is not required to cover an entire band, the configuration in Fig. 4 may be more desirable because only the transmittance values falling within the passband of the MZI, for example 1550 nm in figure 4, may be allowed to pass and possible unwanted frequencies are blocked.

In some embodiments using silica waveguides advantage is taken of the low insertion loss and low temperature sensitivity of such material thus significantly improving the LO laser wavelength stability.

It is noted that the reflective element 126 in the embodiment of figure 1 may cause some optical power loss, for example when a 3dB splitter/combiner is used as reflective element. Such loss may be reduced, if needed, for example by using an integrated mirror.

Furthermore, in order to tune the passbands of the ring resonators (in particular silica-based filters) thermo-optic phase shifters (not shown) may be used to align the frequencies of the resonators with the maximum transmittance of the MZI at the desired resonance or lasing wavelength.

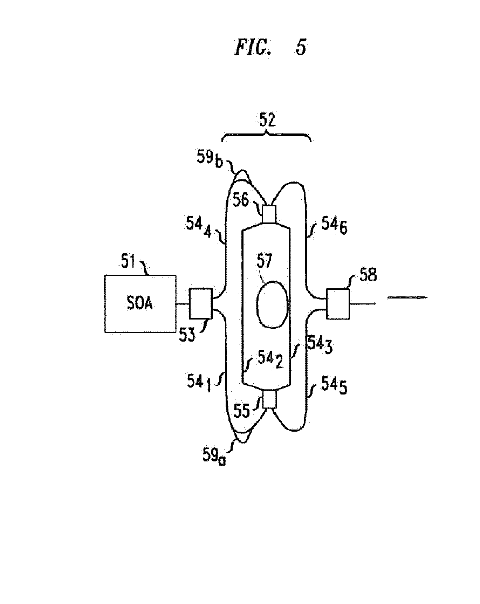

Figure 5 demonstrates an example of an alternative configuration of a hybrid-integrated tunable laser device 5. The device 5 comprises an active SOA 51 coupled in a hybrid manner to a PLC filter 52 adapted to provide filter functionality as will be described below. The structure of the SOA 51 may be made using InP material and that of the PLC filter 52 may be made using silicon-based material (silicon, silicon nitride, polymer-on-silicon or silica). As the laser is hybrid-integrated the construction of the device using such different materials is easily achievable. The coupling of the SOA 51 with the PLC filter 52 may be made by known means using for example a butt-coupled or a flip-chipped approach.

Similarly to the embodiment of figure 1, the SOA 51 may be made separately from the PLC 52 on a die of an InP material and then mounted on a common substrate with the PLC 52 in hybrid manner; or it may be made by epitaxial growth on the InP material that is wafer bonded in a hybrid manner to the PLC wafer and then processed along with the PLC wafer.

In the embodiments of figure 5, the PLC filter 52 comprises phase shifters which are made using a ring-assisted MZI structure instead of coupled-ring resonators as discussed in relation to figure 1. This configuration does not make use of a 3dB combiner/splitter as a reflective element and therefore in this configuration the optical power loss which is typically caused by the 3dB splitter/combiner as discussed in relation to the embodiment of figure 1 is absent.

The SOA 51 is coupled to the PLC filter by means of a splitter/combiner 53. The MZI comprises a first waveguide 54₁, a second waveguide 54₂, a third waveguide 54₃, a forth waveguide 54₄ and a pair of splitter/combiners 55 and 56. The MZI further comprises a ring resonator 57 coupled to one waveguide, for example waveguide 54₃.

With this arrangement, an optical signal generated by the SOA is input into the MZI by means of the splitter/combiner 53. The optical signal is split into the two waveguides 54₁ and 54₄. As the structure of the MZI is symmetrical, and for the sake of briefness, only the propagation of the signal in one direction, namely in the direction of waveguide 54₁ towards waveguides 54₂, 54₃ and waveguide 54₄ (herein also referred to as the first direction) is discussed below, considering that propagation of the optical signal propagating in the direction from waveguide 54₄ to waveguides 54₃, 54₂ and 54₁ (herein also referred to as the second direction) is done in analogous way.

Assuming that the optical signal is directed to the waveguide 54₁, the signal is further split into two components by the splitter/combiner 55, and fed into the waveguide 54₂ and waveguide 54₃. As shown in figure 5, waveguide 54₃ is coupled to a ring resonator 57. The ring resonator 57 is configured to introduce a phase shift in the optical signal that propagates there-through. Such phase shifting property therefore constitutes a filtering effect on the wavelength of the optical signal. In this manner, the component of the optical signal that propagates through the waveguide 54₃ undergoes a phase shift, while the component of the optical signal that propagates through the waveguide 54₂ does not undergo such phase shift. The two components reach splitter/combiner 56 and are output with the phase difference produced by the ring resonator.

The combined signal is fed back to the SOA 51 through the return path provided by waveguide 54₄ and splitter combiner 53. At the SOA 51, the optical signal is further amplified and input into the same path through waveguide 54₁ as described above. The forward and return propagation of the optical signal together with the amplifying effect of the SOA 51 produces the effect of a laser cavity.

As mentioned above a similar effect is produced on the optical signal travelling in the second direction, namely from waveguide 54₄ to waveguide 54₁.

When the lasing resonant frequency is achieved, the optical signals propagating in the first and the second directions are directed toward the output of the laser through output waveguide 54₅ and output waveguide 54₆ and are combined and output from the PLC filter by means of output port 58, for example a 3dB combiner.

The structure may be configured such that the waveforms generated in the first direction have an FSR which is different from the FSR of the waveform generated in the second direction.

The difference in the FSRs of the waveform in the first and the second direction produces a combined effect on the resulting (output) waveform, as some of the

(unwanted) frequencies may cancel each other while a particular (wanted) frequency from each waveform may add up to produce the optical signal to be output from the laser. Therefore, the shape of the combined waveform depends on such difference in the respective FSRs of the waveform in the first and the second direction. Consequently, by appropriately determining such difference in the FSRs, one may be able to determine the wavelength at which a maximum (or at least an optimum) transmittance of the laser may be obtained and thereby tune the response of the laser to that particular wavelength.

On the other hand, the waveguide 54₁ and the waveguide 54₄ are branches of the MZI. The MZI may therefore be configured to introduce an additional first wavelength filtering in the branch comprising waveguide 54₁ and an additional second wavelength filtering in the branch comprising waveguide 54₄ such that the first and the second wavelength filtering effects are different. By appropriately selecting the amount of the first and the second additional wavelength filterings, the tunability of the laser output may be further improved. This is schematically shown in figure 5 by means of wavelength filter elements 59ₐ and 59_{b}.

In this manner, with a hybrid integration of a local oscillator in PLC platform as described above a tunable laser may be provided which may be used as a local oscillator with improved temperature stability, improved yield and relatively lower cost. Additionally, the low loss of the silicon-based waveguides allows realizing high Q ring resonators which may enable narrower laser lines (finely tuned wavelengths) to be produced. Furthermore, the use of a hybrid-integrated tunable LO laser may reduce filter insertion loss leading to higher output power and increase the fabrication tolerances of the filter due to the lower index contrast of the material.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

## Claims

1. A tunable laser comprising a semiconductor optical amplifier constructed in an InP material and at least one planar lightwave circuit filter constructed in silicon-based material, the semiconductor optical amplifier and the planar lightwave circuit filter being integrated in a hybrid structure on a common substrate, wherein the at least one planar lightwave filter comprises a hybrid structure including a first wavelength filter having a first free spectral range and a second wavelength filter having a second free spectral range, the first free spectral range being different from the second free spectral range such that in use, a combined effects of the first wavelength filter and the second wavelength filter produces a plurality of wavelengths; the laser further comprises a third wavelength filter coupled to the first wavelength filter and the second wavelength filter and configured to allow a selected number of wavelengths from said plurality of wavelengths to pass through said third wavelength filter.

2. The Laser of claim 1 wherein the laser is adapted to operate in the C-band or in the L-band.

3. The laser of claim 1 or claim 2 wherein the semiconductor optical amplifier structure in the InP material and the planar waveguide circuit filter in the silicon-based material are distinct dies mounted on a common substrate.

4. The laser of claim 1 or claim 2 wherein the semiconductor optical amplifier structure in the InP material and the planar waveguide circuit filter in the silicon-based material are wafer-bonded structures on a common substrate.

5. The laser of any one of the preceding claims wherein, the silicon-based material is silica, or silicon or silicon nitride or polymer-on-silicon.

6. The laser of any one of the preceding claims wherein, the third wavelength filter is a Mach-Zehnder interferometer.

7. The laser of any one of the preceding claims wherein the first wavelength filter is a ring resonator.

8. The laser of any one of the preceding claims wherein the second wavelength filter is a ring resonator.

9. The laser of any one of the preceding claims wherein the Mach-Zehnder interferometer is tunable to a maximum transmittance of the planar lightwave circuit filter.

10. The laser of any one of the preceding claims wherein, the first free spectral range and the second free spectral range have a difference smaller than about 1 GHz.

11. The laser of any one of the preceding claims further thermo-optic phase shifters configured to provide aligning of the frequencies of the resonators with the maximum transmittance of the MZI at a desired lasing wavelength.

12. A receiver comprising the laser as claimed in any one of the preceding claims.

13. A transmitter comprising the laser as claimed in any one of the claims 1 to 11.
